# FASCICULE DE BREVET EUROPEEN

(11) **EP 1 079 425 B1**
(45) Date de publication et mention de la délivrance du brevet: **07.03.2018**
(21) Numéro de dépôt: 00402191.1
(22) Date de dépôt: 31.07.2000
(51) Int. Cl.: H01L 21/3065, H01L 21/3213

(54) **Procédé et dispositif pour le traitement de substrat sous vide par plasma.**
Verfahren und Einrichtung zur Vakuum-Plasma-Behandlung eines Substrats
Process and device for vacuum plasma treatment of substrate

(30) Priorité: 26.08.1999 FR 9910799
(43) Date de publication de la demande: 28.02.2001
(73) Titulaire: Tegal Corporation, Petaluma, CA 94954 (US)
(72) Inventeur: Puech, Michel, 74370 Metz Tessy (FR)
(74) Mandataire: Santarelli

(56) Documents cités:
- EP-A- 0 363 982
- EP-A- 0 651 432
- EP-A- 0 837 155
- US-A- 4 579 623
- PATENT ABSTRACTS OF JAPAN vol. 013, no. 404 (E-817), 7 septembre 1989 (1989-09-07) & JP 01 146327 A (FUJITSU LTD), 8 juin 1989 (1989-06-08)

## Description

La présente invention concerne le traitement d'un substrat sous vide par plasma, pour la gravure ou le dépôt.

On connaît déjà des procédés de traitement de substrat sous vide par plasma, tels que le procédé de gravure décrit dans le document WO 94/14187, dans lequel le substrat est placé dans une enceinte à vide contenant des gaz actifs injectés notamment par des moyens contrôlés d'injection de gaz actif et évacués par des moyens contrôlés d'aspiration de gaz. Les gaz actifs sont ionisés par des moyens de génération de plasma. Le substrat, placé dans l'enceinte à vide, reçoit une énergie électrique de bombardement générée par un générateur contrôlé d'énergie de bombardement auquel il est connecté.

Lors d'une étape de gravure, des ions de matière réactive telle que l'hexafluorure de soufre, générés par ionisation, sont accélérés par l'énergie de bombardement et viennent frapper le substrat tel qu'un substrat à base de silicium dans les zones non occultées par un masque. Les ions actifs se combinent avec la matière formant le substrat, pour former un composé gazeux qui est évacué par les moyens d'aspiration de gaz.

Une difficulté est de réaliser une gravure à contours bien définis, c'est-à-dire dans laquelle les cavités comportent des parois latérales aussi régulières que possible et perpendiculaires à la surface du substrat.

Pour cela, le document WO 94/14187 enseigne de réaliser la gravure par une succession alternée d'étapes de gravure et d'étapes de génération de couche de protection. Au cours d'une étape de génération de couche de protection, l'enceinte à vide contient un gaz actif d'un premier type tel que le trifluorométhane CHF3, qui produit une couche polymérisée sur toute la surface de substrat, comprenant la surface de fond de cavité à réaliser et les faces latérales de la cavité. Au cours d'une étape de gravure, l'enceinte à vide contient un gaz actif d'un second type tel que l'hexafluorure de soufre, qui produit des ions que l'on accélère en direction du substrat pour produire un bombardement directionnel venant frapper sélectivement le fond des cavités, pour enlever de la matière du substrat sélectivement dans le fond de cavité en évitant d'attaquer les faces latérales.

On comprend cependant que l'étape de gravure conduit à abaisser le fond de la cavité par rapport à la base de la couche de protection polymérisée latérale, de sorte qu'il apparaît à la base de la face latérale une zone non protégée par une couche de matière polymérisée, et le bombardement d'ions actifs tend à creuser latéralement en élargissant le fond de la cavité, affectant la régularité de la face latérale de cavité.

Pour éviter ce phénomène, il est nécessaire d'utiliser une alternance rapide d'étapes courtes de gravure et de génération de couche de protection.

Un problème est aussi d'optimiser les performances de gravure et de génération de couche de protection.

Dans la plupart des procédés de traitement sous vide par plasma (gravure ou dépôt), les principaux paramètres sur lesquels on peut agir pour optimiser les performances de gravure ou de dépôt sont : les débits des différents gaz, la pression de travail, la puissance électromagnétique couplée au plasma pour générer celui-ci, et l'énergie de bombardement du substrat.

Les performances de gravure ou de dépôt, comme la vitesse de dépôt ou de gravure, la sélectivité par rapport au masque, la régularité des profils de gravure, la conformité des couches déposées, dépendent des conditions de la décharge en phase gazeuse en terme de puissance couplée au plasma, de pression de travail et d'énergie de bombardement du substrat.

En règle générale, pour optimiser un procédé de dépôt ou de gravure, on optimise les débits des différents gaz, la puissance électromagnétique couplée au plasma, et l'énergie de bombardement du substrat à des valeurs précises et constantes tout au cours du traitement.

Par exemple, si l'on veut graver par plasma des motifs dans une tranche de silicium, on fixe les débits de gaz actifs à des valeurs bien précises et constantes, la puissance électromagnétique couplée au plasma à une valeur précise, ainsi que la valeur de la pression de travail et la tension de polarisation qui détermine l'énergie de bombardement du substrat par les ions. Ces valeurs sont maintenues constantes tout au long de l'étape de traitement. Notamment, on fixe les débits gazeux à une valeur bien précise et, à l'aide d'un système de régulation de pression, on maintient celle-ci à une valeur prédéterminée. En général, ce système de régulation de pression est constitué d'un système de pompage comprenant au moins une pompe en amont de laquelle se trouve une vanne de régulation asservie à la pression de travail, constituant ainsi des moyens contrôlés d'aspiration de gaz. Ainsi, quels que soient les débits gazeux requis, la vanne de régulation de la pression se positionne de manière telle qu'elle assure la pression de travail requise dans la chambre de réaction.

De tels moyens contrôlés d'aspiration de gaz fonctionnent correctement pour assurer une régulation de pression lors de variations lentes des débits gazeux. Toutefois, il apparaît que de tels moyens contrôlés d'aspiration de gaz ne permettent pas de suivre efficacement les variations rapides de débits gazeux, telles que les variations susceptibles de se produire si l'on veut optimiser à la fois les étapes de gravure et les étapes de génération de couche de protection dans un procédé de gravure selon le document WO 94/14187 en alternant les étapes de gravure et de génération de couche de protection à une fréquence suffisamment élevée pour réaliser des faces latérales de cavité suffisamment régulières. Par exemple, on peut trouver intérêt dans l'alternance de phases de gravure d'une durée d'environ trois secondes et de phases de génération de couche de protection d'une durée d'environ une seconde. L'inertie mécanique de la vanne de régulation asservie ne permet pas de suivre de telles variations rapides si le débit de gaz au cours de l'étape de gravure est différent du débit de gaz au cours de l'étape de génération de couche de protection.

L'inertie mécanique de la vanne de régulation asservie ne permet pas, non plus, de régler rapidement la pression gazeuse à deux valeurs successives différentes pour optimiser deux étapes successives courtes de traitement.

Une autre difficulté est que, si la pression gazeuse varie à l'intérieur de l'enceinte à vide, entre deux étapes successives, cela produit une variation de l'impédance du plasma vue par le générateur contrôlé d'énergie de bombardement connecté au substrat, et il n'est alors plus possible de contrôler efficacement l'énergie de bombardement pour assurer la régularité du procédé.

Le générateur contrôlé d'énergie de bombardement est généralement associé à un adaptateur d'impédance destiné à adapter l'impédance de la source d'énergie à celle du plasma. L'adaptateur d'impédance peut suivre des variations lentes de l'impédance du plasma, en comprenant pour cela un condensateur à capacité variable réglable par déplacement mécanique des armatures du condensateur l'une par rapport à l'autre. Cependant, un tel dispositif n'est pas capable de suivre des variations rapides d'impédance, c'est-à-dire des variations se produisant à une fréquence de l'ordre du Hertz.

Le problème proposé par la présente invention est ainsi de concevoir un procédé et un dispositif dans lequel on peut faire varier rapidement le flux de gaz actif dans l'enceinte à vide pour traitement d'un substrat par plasma, sans perturber les moyens de contrôle et de régulation de bombardement du substrat par les ions.

Un autre objet de l'invention est de concevoir des moyens permettant de travailler en asservissement de pression dans l'enceinte à vide, assurant un asservissement par les moyens contrôlés d'aspiration de gaz traditionnels à vanne de régulation de pression, tout en autorisant des débits de gaz actif rapidement variables.

Pour atteindre ces objets ainsi que d'autres, un procédé de traitement de substrat sous vide par plasma selon l'invention est défini dans la revendication 1. Ce procédé est tel que le substrat est placé dans une enceinte à vide contenant notamment des gaz actifs injectés par des moyens contrôlés d'injection de gaz actif et évacués par des moyens contrôlés d'aspiration de gaz, les gaz actifs étant ionisés par des moyens de génération de plasma, le substrat recevant une énergie électrique de bombardement générée par un générateur contrôlé d'énergie de bombardement ; le procédé comprend au moins une séquence de variation du flux d'injection de gaz actif selon une vitesse de variation supérieure à la capacité de régulation de pression gazeuse dans l'enceinte à vide assurée par les moyens contrôlés d'aspiration de gaz ; au cours de cette séquence de variation du flux d'injection de gaz actif, par action de moyens de compensation auxiliaires, on maintient à un niveau sensiblement constant l'impédance du plasma vue par le générateur contrôlé d'énergie de bombardement. Le maintien à un niveau sensiblement constant de l'impédance du plasma vue par le générateur contrôlé d'énergie de bombardement s'effectue par injection contrôlée d'au moins un gaz passif de contrôle dans l'enceinte à vide, de façon à maintenir à un niveau sensiblement constant le flux total d'injection de gaz dans l'enceinte à vide. L'expression "gaz passif de contrôle" désigne un gaz qui n'a pas d'effet sensible sur l'opération elle-même de gravure ou de dépôt en cours sur le substrat. Le gaz passif de contrôle est injecté dans l'enceinte à vide dans une zone proche des moyens contrôlés d'aspiration de gaz, de façon à éviter son ionisation.

Selon une première application, le procédé comprend une succession d'étapes d'injection de gaz actif selon un premier débit d'injection et d'étapes d'injection de gaz actif selon un second débit d'injection différent du premier débit d'injection, certaines au moins des étapes étant plus courtes que le temps de réaction des moyens contrôlés d'aspiration de gaz.

La puissance de bombardement communiquée au substrat peut différer d'une étape à l'autre.

Le procédé peut s'appliquer à la gravure d'un substrat, par exemple d'un substrat à base de silicium. Dans ce cas, on peut avantageusement utiliser une succession de courtes étapes comprenant, en alternance, une étape de gravure dans laquelle le premier gaz actif est le SF6 pendant une première durée selon un premier débit, et une étape de génération d'une couche de protection dans laquelle le second gaz actif est le C4F8 pendant une seconde durée selon un second débit avec injection simultanée d'un débit complémentaire de gaz passif de contrôle tel que l'azote ou l'argon.

En alternative, le procédé peut s'appliquer à la réalisation d'un dépôt sur un substrat.

Un dispositif de traitement de substrat sous vide par plasma selon l'invention, pour la mise en oeuvre d'un tel procédé, est défini dans la revendication 7. Il comprend :
- une enceinte à vide,
- des moyens contrôlés d'injection de gaz actif dans l'enceinte à vide,
- des moyens contrôlés d'aspiration de gaz hors de l'enceinte à vide,
- des moyens de génération de plasma dans l'enceinte à vide,
- des moyens supports de substrat pour supporter le substrat dans l'enceinte à vide,
- un générateur contrôlé d'énergie de bombardement adapté pour communiquer au substrat placé sur les moyens supports de substrat une énergie appropriée de bombardement,
- des moyens de compensation auxiliaires, maintenant à un niveau sensiblement constant l'impédance du plasma vue par le générateur contrôlé d'énergie de bombardement dans le cas de variations de débit d'entrée de gaz et de maintien sensiblement constant de débit d'aspiration de gaz. Les moyens de compensation auxiliaires comprennent des moyens d'injection contrôlés d'au moins un gaz passif de contrôle dans l'enceinte à vide. Les moyens d'injection contrôlés de gaz de contrôle sont adaptés pour injecter le gaz passif de contrôle en une zone d'enceinte à vide proche des moyens d'aspiration de gaz. Le dispositif comprend des moyens de commande pour commander les moyens d'injection contrôlés de gaz de contrôle de façon à maintenir à un niveau sensiblement constant le flux total d'injection de gaz dans l'enceinte à vide.

D'autres objets, caractéristiques et avantages de la présente invention ressortiront de la description suivante de modes de réalisation particuliers, faite en relation avec les figures jointes, parmi lesquelles:
- la figure 1 illustre schématiquement un dispositif de traitement de substrat sous vide par plasma selon un mode de réalisation de la présente invention ;
- la figure 2 est un diagramme temporel illustrant les variations de débit des différents gaz introduits dans la chambre à vide lors d'un procédé de traitement de substrat sous vide par plasma selon un mode de réalisation de l'invention ; et
- les figures 3 et 4 sont des coupes latérales d'un substrat, illustrant l'application d'un procédé de l'invention à la gravure du substrat.

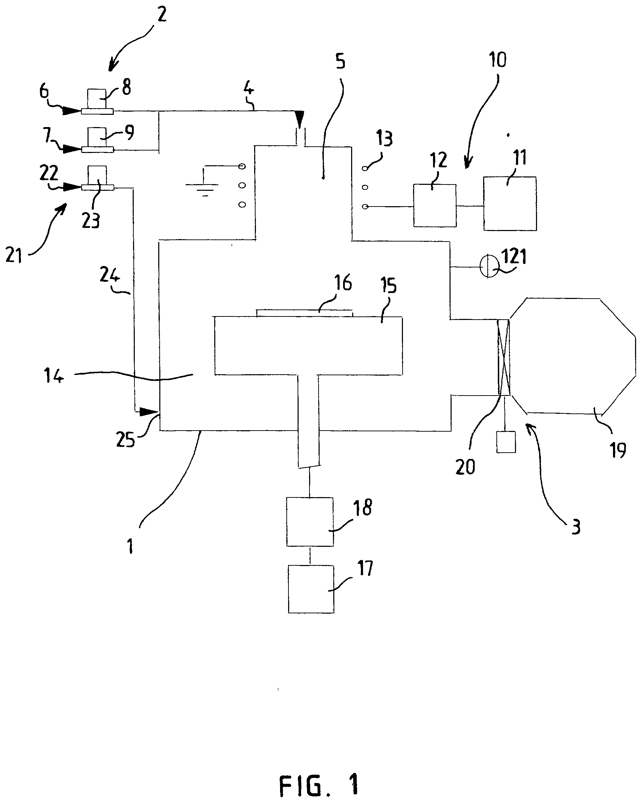

Dans le mode de réalisation illustré sur la figure 1, le dispositif de traitement de substrat sous vide par plasma comprend une enceinte à vide 1, avec des moyens contrôlés d'injection de gaz actif 2 dans l'enceinte à vide 1 et des moyens contrôlés d'aspiration de gaz 3 hors de l'enceinte à vide 1.

Les moyens contrôlés d'injection de gaz actif 2 comprennent par exemple une canalisation d'amenée de gaz actif 4, connectée à la zone supérieure 5 de l'enceinte à vide 1, et recevant par exemple un premier gaz actif G1 provenant d'une première source de gaz actif 6 et un second gaz actif G2 provenant d'une seconde source de gaz actif 7, chaque source de gaz actif étant associée à un débitmètre respectif 8 ou 9.

La zone supérieure 5 de l'enceinte à vide 1 comprend également des moyens de génération de plasma 10, avec un générateur haute fréquence d'excitation 11 connecté par un adaptateur d'impédance d'excitation 12 à une bobine d'excitation 13. Par l'effet des moyens de génération de plasma 10, les gaz présents dans la zone supérieure de l'enceinte à vide 1 sont ionisés, constituant un plasma gazeux.

Dans la partie inférieure 14 de l'enceinte à vide 1, un porte-substrat 15 permet de supporter un substrat 16 à traiter. Le substrat 16 est orienté en direction de la zone supérieure 5 contenant le plasma gazeux. Le porte-substrat 15 est connecté électriquement à un générateur contrôlé d'énergie de bombardement 17, par l'intermédiaire d'un adaptateur d'impédance de bombardement 18.

Les moyens contrôlés d'aspiration de gaz 3 comprennent des moyens de pompage des gaz 19, dont l'entrée d'aspiration est raccordée à la partie inférieure 14 de l'enceinte à vide 1 par l'intermédiaire d'une vanne asservie en pression 20. La vanne asservie en pression 20 est pilotée par un dispositif de commande, non représenté, recevant les informations d'une jauge de pression 121 adaptée pour capter la pression à l'intérieur de l'enceinte à vide 1.

Le dispositif selon l'invention comprend en outre des moyens de compensation auxiliaires, pour maintenir à un niveau constant l'impédance du plasma vue par le générateur contrôlé d'énergie de bombardement 17 dans le cas d'une variation de débit d'entrée des gaz introduits par la canalisation d'amenée de gaz actif 4 et d'un maintien sensiblement constant du débit d'aspiration de gaz à travers la vanne asservie en pression 20.

Dans le mode de réalisation illustré, ces moyens de compensation auxiliaires comprennent des moyens d'injection contrôlés de gaz de contrôle 21. Par exemple, les moyens d'injection contrôlés de gaz de contrôle 21 comprennent une source de gaz de contrôle 22, un débitmètre de contrôle 23 et une canalisation auxiliaire 24 adaptée pour injecter un gaz de contrôle G3 en une zone 25 d'enceinte à vide proche des moyens contrôlés d'aspiration de gaz 3.

Les débitmètres 8, 9 et 23 sont adaptés pour commander respectivement le débit d'entrée des gaz actifs G1 et G2 et du gaz de contrôle G3, et sont pilotés pour cela par des moyens de commande non représentés sur la figure.

Selon l'invention, les moyens de commande sont de préférence adaptés pour commander les moyens d'injection de gaz de contrôle, c'est-à-dire le débitmètre 23, de façon à maintenir un niveau sensiblement constant du flux total d'injection de gaz à l'intérieur de l'enceinte à vide 1 lors d'une variation du débit des gaz actifs entrant par la canalisation d'amenée de gaz actif 4.

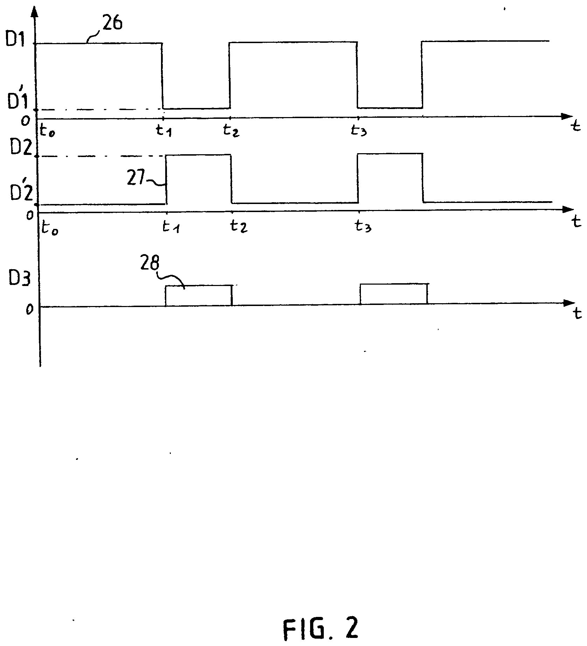

La figure 2 illustre un exemple de régulation selon l'invention : la courbe 26 est un diagramme temporel du débit D1 d'un premier gaz actif G1 dans la canalisation d'amenée de gaz actif 4, présentant en succession une étape à débit maximum D1 constant, par exemple de l'instant t0 à l'instant t1, suivie d'un débit minimum D'1, éventuellement nul, de l'instant t1 à l'instant t2, puis d'un débit maximum D1 de l'instant t2 à l'instant t3, etc. La courbe 27 est un diagramme temporel du débit D2 d'un second gaz actif G2, dans lequel le débit est minimum D'2, éventuellement nul, entre les instants t0 et t1, puis est maximal égal à D2 entre les instants t1 et t2, puis redevient minimum D'2 entre les instants t2 et t3, etc.

L'étape entre les instants t0 et t1 peut par exemple correspondre à une étape de gravure, tandis que l'étape entre les instants t1 et t2 peut par exemple correspondre à une étape de génération de couche de protection.

On voit qu'entre les instants t1 et t2, le débit D2 + D'1 est inférieur au débit D1 + D'2 entre les instants t0 et t1. Par conséquent, le débit total de gaz actifs prend une valeur supérieure D1 + D'2 entre les instants t0 et t1, et une valeur plus faible D2 + D'1 entre les instants t1 et t2.

Selon l'invention, entre les instants t1 et t2, on injecte un gaz passif de contrôle G3, selon un débit D3 sensiblement égal à (D1 + D'2) - (D2 + D'1), comme illustré par la courbe 28, par les moyens d'injection contrôlés de gaz de contrôle 21.

Grâce au complément constitué par le gaz passif de contrôle G3, le débit total de gaz pénétrant dans l'enceinte à vide 1 est maintenu sensiblement constant, quel que soit le débit des gaz actifs alternés G1 et G2 utilisés. Il en résulte que la pression gazeuse à l'intérieur de l'enceinte à vide 1 est sensiblement constante, et que l'impédance du plasma est également sensiblement constante. De la sorte, l'adaptateur d'impédance de bombardement 18 fonctionne correctement pour transmettre au substrat 16 une énergie de bombardement contrôlée, et la vanne asservie en pression 20 fonctionne correctement pour l'asservissement lent de pression à l'intérieur de l'enceinte à vide 1.

En introduisant le gaz passif de contrôle G3 dans la zone 25 d'enceinte à vide 1 proche des moyens contrôlés d'aspiration de gaz 3, on évite encore que le gaz de contrôle soit ionisé dans le plasma et participe ainsi de quelque manière que ce soit aux résultats du traitement en cours du substrat 16.

Ainsi, l'invention permet de pallier à l'incapacité des systèmes d'asservissement de pression et d'adaptation d'impédance, utilisés dans les systèmes de gravure ou de dépôt sous vide par plasma, à pouvoir répondre à des variations de débit de gaz actifs dans des temps de l'ordre de la seconde.

Par conséquent, le dispositif selon l'invention tel qu'illustré sur la figure 1 permet de choisir des débits de gaz G1 et G2 différents lors d'étapes successives de traitement, pour optimiser chacune des étapes.

Dans un procédé de traitement de substrat sous vide par plasma selon l'invention, il se produit au moins à certains instants une variation brusque du flux d'injection global de gaz actif, la variation de flux se produisant à une vitesse de variation supérieure à la capacité de régulation de pression gazeuse dans l'enceinte à vide 1 assurée par les moyens contrôlés d'aspiration de gaz 3. Par exemple, de telles variations de flux d'injection de gaz actif se produisent aux instants t1, t2 ou t3 de la figure 2. Par action des moyens de compensation auxiliaires, constitués par les moyens d'injection contrôlés de gaz de contrôle 21, on maintient à un niveau sensiblement constant l'impédance du plasma vue par le générateur contrôlé d'énergie de bombardement 17 et son adaptateur d'impédance de bombardement 18.

Ce maintien à un niveau sensiblement constant de l'impédance du plasma vue par le générateur contrôlé d'énergie de bombardement 17 s'effectue par injection contrôlée d'au moins un gaz passif de contrôle G3 dans l'enceinte à vide 1, qui permet de conserver dans l'enceinte à vide 1 une pression gazeuse sensiblement constante.

Une application du procédé de l'invention permet par exemple la gravure du substrat 16. Pour la gravure d'un substrat 16 à base de silicium, on peut utiliser une succession de courtes étapes comprenant, en alternance, une étape de gravure dans laquelle le premier gaz actif G1 est l'hexafluorure de soufre SF6 pendant une première durée T1 = t1 - t0 selon un premier débit D1, et une étape de génération d'une couche de protection dans laquelle le second gaz actif G2 est le gaz C4F8 pendant une seconde durée T2 = t2 - t1 selon un second débit D2 avec injection d'un débit complémentaire D3 = D1 - D2 d'un gaz passif de contrôle G3 tel que l'azote ou l'argon. Par exemple, D1 = 300 Sccm de SF6 pendant 3 secondes et D2 = 200 Sccm de C4F8 pendant une seconde. D3 = 100 Sccm, simultanément au débit D2.

Naturellement, selon l'invention, en fonction de la nature du substrat à traiter et du type de traitement, on pourra choisir d'autres gaz actifs, d'autres gaz passifs, et d'autres paramètres de durée et de débit gazeux.

Grâce à la capacité d'adaptation rapide du dispositif selon la présente invention, il est possible d'alterner rapidement des étapes successives de traitement dans lesquelles les débits de gaz actifs sont différents. Il est également possible de faire varier rapidement le débit d'un même gaz actif.

L'invention s'applique aussi bien à la gravure qu'à la réalisation de dépôts.

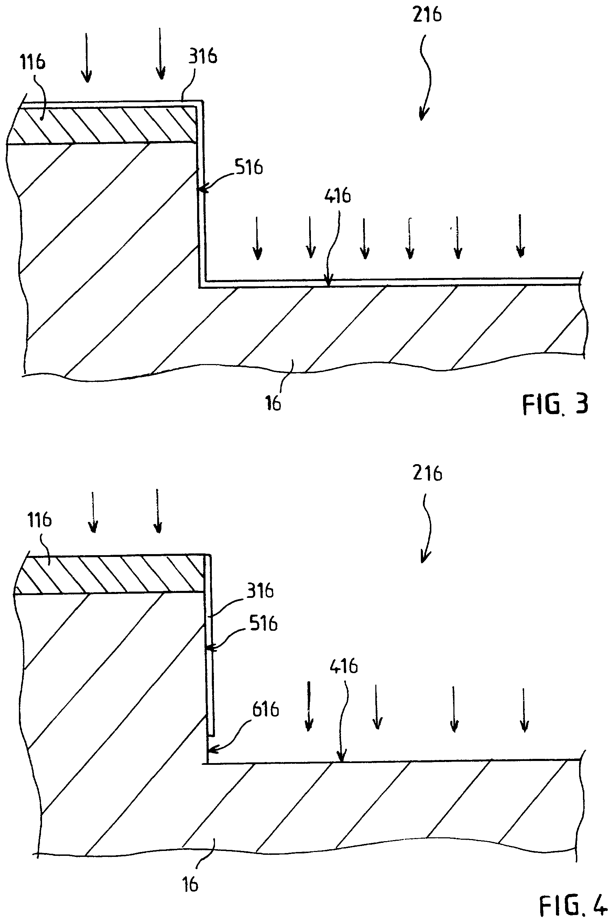

Les figures 3 et 4 illustrent une application possible du procédé de l'invention pour la gravure.

Sur la figure 3, on a illustré l'étape de génération d'une couche de protection : le substrat 16, recouvert partiellement par le masque 116, comporte déjà, dans un espace non recouvert par le masque 116, une cavité 216. Lors de l'étape de génération de la couche de protection, le gaz de passivation génère une couche 316 de protection sur toute la surface supérieure, non seulement sur les surfaces horizontales dont le fond 416 de la cavité 216, mais également sur la face latérale 516 de la cavité 216.

Au cours de l'étape de gravure illustrée sur la figure 4, le bombardement ionique s'effectue de façon directionnelle en direction du fond 416 de la cavité 216 et provoque l'abaissement progressif du fond 416. On retrouve encore, sur la face latérale 516, la couche de protection 316. Toutefois, par suite de l'abaissement du niveau du fond 416, une portion inférieure 616 de la face latérale 516 se trouve dépourvue de couche de protection 316. C'est pour cela qu'il faut alterner des étapes courtes de gravure (figure 4) et de génération de couche de protection (figure 3), et donc travailler à une fréquence suffisamment élevée par exemple de l'ordre du Hertz.

La présente invention n'est pas limitée aux modes de réalisation qui ont été explicitement décrits, mais elle en inclut les diverses variantes et généralisations qui sont à la portée de l'homme du métier.

## Revendications

1. Procédé de traitement de substrat sous vide par plasma, selon lequel le substrat (16} est placé dans une enceinte à vide (1) contenant notamment des gaz actifs injectés par des moyens contrôlés d'injection de gaz actif (2) et évacués par des moyens contrôlés d'aspiration de gaz (3}, les gaz actifs étant ionisés par des moyens de génération de plasma (10), le substrat (16) recevant une énergie électrique de bombardement générée par un générateur contrôlé d' énergie de bombardement (17, 18), **caractérisé en ce que** :
le procédé comprend au moins une séquence de variation du flux d'injection de gaz actif selon une vitesse de variation supérieure à la capacité de régulation de pression gazeuse dans l'enceinte à vide (1) assurée par les moyens contrôlés d'aspiration de gaz (3),
- l'impédance du plasma vue par le générateur contrôlé d'énergie de bombardement (17, 18) est maintenue à un niveau sensiblement constant au cours de cette séquence de variation du flux d'injection de gaz actif, par action de moyens de compensation auxiliaires (21) comprenant des moyens d'injection contrôlés dans l'enceinte à vide (1) d'au moins un gaz passif de contrôle (G3) en maintenant sensiblement constant le débit d'aspiration de gaz, dans une zone (25) proche des moyens contrôlés d'aspiration de gaz (3) de façon à éviter son ionisation,
- ces moyens d'injection étant commandés de façon à maintenir à un niveau sensiblement constant le flux total d'injection de gaz dans l'enceinte à vide (1).

2. Procédé selon la revendication 1, **caractérisé en ce qu'**il comprend une succession d'étapes d'injection de gaz actif selon un premier débit d'injection (D1) et d'étapes d'injection de gaz actif selon un second débit d'injection (D2) différent du premier débit d'injection (D1), certaines au moins des étapes étant plus courtes que le temps de réaction des moyens contrôlés d'aspiration de gaz (3).

3. Procédé selon la revendication 2, dans lequel la puissance de bombardement communiquée au substrat (16) diffère d'une étape à l'autre.

4. Procédé selon l'une des revendications 1 à 3 appliqué à la gravure du substrat (16).

5. Procédé selon la revendication 4, dans lequel, pour la gravure d'un substrat (16) à base de silicium, on utilise une succession de courtes étapes comprenant, en alternance, une étape de gravure dans laquelle le premier gaz actif (G1) est le SF6 pendant une première durée (T1) selon un premier débit (D1), et une étape de génération d'une couche de protection dans laquelle le second gaz actif (G2) est le C4F8 pendant une seconde durée (T2) selon un second débit (D2), avec injection simultanée d'un débit complémentaire (D3 = D1 - D2) d'un gaz passif de contrôle (G3) tel que l'azote ou l'argon.

6. Procédé selon l'une des revendications 1 à 3, appliqué à la réalisation d'un dépôt sur le substrat (16).

7. Dispositif de traitement de substrat (16) sous vide par plasma, permettant la mise en oeuvre d'un procédé selon la revendication 1, comprenant :
- une enceinte à vide (1),
- des moyens contrôlés d'injection de gaz actif (2) dans l'enceinte à vide (1),
- des moyens contrôlés d'aspiration de gaz (3) hors de l'enceinte à vide (1),
- des moyens de génération de plasma (10) dans l'enceinte à vide (1),
- des moyens supports de substrat (15) pour supporter le substrat (16) dans l'enceinte à vide (1),
- un générateur contrôlé d'énergie de bombardement (17) adapté pour communiquer au substrat (16) placé sur les moyens supports de substrat (15) une énergie appropriée de bombardement,
**caractérisé en ce que** :
• il comprend en outre des moyens de compensation auxiliaires (21) maintenant à. un niveau sensiblement constant l'impédance du plasma vue par le générateur contrôlé d'énergie de bombardement (17) dans le cas de variations de débit d"entrée de gaz et maintenant sensiblement constant le débit d'aspiration de gaz,
• les moyens de compensation auxiliaires (21} comprenant des moyens d'injection contrôlés dans l'enceinte à vide (1) d'au moins un gaz passif de contrôle (G3) dans une zone (25) proche des moyens contrôlés d'aspiration de gaz (3) de façon à éviter son ionisation,
• ces moyens d'injection étant commandés par des moyens de commande (23) de façon à maintenir à un niveau sensiblement constant le flux total d'injection de gaz dans l'enceinte à vide (1).

## Patentansprüche

1. Verfahren zur Vakuum-Plasma-Behandlung eines Substrats, wobei das Substrat (16) in einer Vakuumkammer (1) angeordnet wird, die insbesondere aktive Gase enthält, die über steuerbare Einleitmittel (2) zum Einleiten von aktivem Gas eingeleitet werden und über steuerbare Gasabsaugmittel (3) abgeführt werden, wobei die aktiven Gase über Plasmaerzeugungsmittel (10) ionisiert werden, wobei das Substrat (16) eine elektrische Beschuss-Energie aufnimmt, die von einem steuerbaren Beschuss-Energiegenerator (17, 18) erzeugt wird,
**dadurch gekennzeichnet, dass**
- das Verfahren zumindest eine Sequenz zum Ändern des Einleitstroms von aktivem Gas gemäß einer Änderungsgeschwindigkeit umfasst, die höher als die Gasdruckregelkapazität in der Vakuumkammer (1) ist, die über die steuerbaren Gasabsaugmittel (3) sichergestellt wird,
- die Impedanz des Plasmas, von dem steuerbaren Beschuss-Energiegenerator (17, 18) aus gesehen, während dieser Änderungssequenz zum Ändern des Einleitstroms von aktivem Gas auf einem im Wesentlichen konstanten Niveau durch Einwirken von Ausgleichshilfsmitteln (21) gehalten wird, die steuerbare Einleitmittel zum Einleiten zumindest eines passiven Kontrollgases (G3) in die Vakuumkammer (1) aufweisen, wobei die Gasabsaugmenge im Wesentlichen konstant gehalten wird, und zwar in einem Bereich (25) nahe bei den steuerbaren Gasabsaugmitteln (3), so dass dessen Ionisierung vermieden wird,
- wobei diese Einleitmittel so gesteuert werden, dass der gesamte Gaseinleitstrom in die Vakuumkammer (1) auf einem im Wesentlichen konstanten Niveau gehalten wird.

2. Verfahren nach Anspruch 1,
**dadurch gekennzeichnet, dass**
es eine Folge von Schritten zum Einleiten von aktivem Gas mit einer ersten Einleitmenge (D1) und Schritte zum Einleiten von aktivem Gas mit einer zweiten Einleitmenge (D2) umfasst, die sich von der ersten Einleitmenge (D1) unterscheidet, wobei zumindest bestimmte der Schritte kürzer sind als die Reaktionszeit der steuerbaren Gasabsaugmittel (3).

3. Verfahren nach Anspruch 2, wobei die dem Substrat (16) übertragene Beschussleistung von einem Schritt zum nächsten unterschiedlich ist.

4. Verfahren nach einem der Ansprüche 1 bis 3, das beim Ätzen des Substrats (16) angewendet wird.

5. Verfahren nach Anspruch 4, wobei zum Ätzen eines Substrats (16) auf Siliciumbasis eine Folge von kurzen Schritten Anwendung findet, die wechselweise einen Ätzschritt, in welchem während einer ersten Zeitdauer (T1) gemäß einer ersten Durchsatzmenge (D1) ein erstes aktives Gas (G1) SF6 ist, und einen Schritt des Erzeugens einer Schutzschicht umfasst, in welchem während einer zweiten Zeitdauer (T2) gemäß einer zweiten Durchsatzmenge (D2) das zweite aktive Gas (G2) C4F8 ist, mit gleichzeitigem Einleiten einer komplementären Durchsatzmenge (D3 = D1 - D2) eines passiven Kontrollgases (G3), wie etwa Stickstoff oder Argon.

6. Verfahren nach einem der Ansprüche 1 bis 3, das beim Herstellen einer Abscheidung auf dem Substrat (16) Anwendung findet.

7. Vorrichtung zur Vakuum-Plasma-Behandlung eines Substrats (16), mit der ein Verfahren nach Anspruch 1 durchgeführt werden kann,
umfassend:
- eine Vakuumkammer (1),
- steuerbare Einleitmittel (2) zum Einleiten von aktivem Gas in die Vakuumkammer (1),
- steuerbare Absaugmittel (3) zum Absaugen von Gas aus der Vakuumkammer (1),
- Plasmaerzeugungsmittel (10) zum Erzeugen eines Plasmas in der Vakuumkammer (1),
- Substrathaltemittel (15) zum Halten des Substrats (16) in der Vakuumkammer (1),
- einen steuerbaren Beschuss-Energiegenerator (17), der dazu ausgelegt ist, dem an den Substrathaltemitteln (15) angeordneten Substrat (16) eine geeignete Beschuss-Energie zuzuführen,
**dadurch gekennzeichnet, dass**
• sie ferner Ausgleichshilfsmittel (21) enthält, welche die Impedanz des Plasmas von dem steuerbaren Beschuss-Energiegenerator (17) aus gesehen bei Gaseinlassmengenänderungen auf einem im Wesentlichen konstanten Niveau halten und die Gasabsaugmenge im Wesentlichen konstant halten,
• wobei die Ausgleichshilfsmittel (21) steuerbare Einleitmittel zum Einleiten von zumindest einem passiven Kontrollgases (G3) in die Vakuumkammer in einem Bereich (25) nahe bei den Gasabsaugmitteln (3) enthalten, so dass deren Ionisierung vermieden wird,
• wobei diese Einleitmittel über Steuermittel (23) so gesteuert werden, dass sie den gesamten Gaseinleitstrom in die Vakuumkammer (1) auf einem im Wesentlichen konstanten Niveau halten.

## Claims

1. Method for treating a substrate under vacuum by plasma, wherein the substrate (16) is placed in a vacuum chamber (1) containing in particular active gases injected by controlled active-gas injection means (2) and discharged by controlled gas-aspiration means (3), the active gases being ionised by plasma-generation means (10), the substrate (16) receiving electrical bombardment energy generated by a controlled bombardment-energy generator (17, 18), **characterised in that**:
- the method comprises at least one sequence of varying the injection flow of active gas at a variation rate greater than the gas-pressure regulation capacity in the vacuum chamber (1) provided by the controlled gas-aspiration means (3),
- the impedance of the plasma seen by the controlled bombardment-energy generator (17, 18) is maintained at a substantially constant level during this sequence of varying the active-gas injection flow, by the action of auxiliary compensation means (21) comprising controlled means for the injection into the vacuum chamber (1) of at least one passive control gas (G3) while keeping the gas-aspiration rate substantially constant, in a zone (25) close to the controlled gas-aspiration means (3) so as to prevent ionisation thereof,
- these injection means being controlled so as to maintain at a substantially constant level the total flow injecting gas into the vacuum chamber (1).

2. Method according to claim 1, **characterised in that** it comprises a succession of steps of injecting active gas at a first injection rate (D1) and steps of injecting active gas at a second injection rate (D2) different from the first injection rate (D1), at least some of the steps being shorter than the reaction time of the controlled gas-aspiration means (3).

3. Method according to claim 2, in which the bombardment power communicated to the substrate (16) differs from one step to another.

4. Method according to any of claims 1 to 3, applied to the etching of the substrate (16).

5. Method according to claim 4, in which, for etching a silicon-based substrate (16), a succession of short steps is used comprising, in alternation, an etching step in which the first active gas (G1) is SF₆ for a first period (T1) at a first rate (D1), and a step of generating a protective layer in which the second active gas (G2) is C₄F₈ for a second period (T2) at a second rate (D2), with simultaneous injection of a supplementary flow (D3 = D1 - D2) of a passive control gas (G3) such as nitrogen or argon.

6. Method according to any of claims 1 to 3, applied to the production of a deposit on the substrate (16).

7. Device for treating a substrate (16) under vacuum by plasma, enabling the implementation of a method according to claim 1, comprising:
- a vacuum chamber (1),
- controlled means (2) for injecting active gas into the vacuum chamber (1),
- controlled means (3) for aspirating gas out of the vacuum chamber (1),
- means (10) for generating plasma in the vacuum chamber (1),
- substrate-support means (15) for supporting the substrate (16) in the vacuum chamber (1) ,
- a controlled bombardment-energy generator (17) suitable for communicating a suitable bombardment energy to the substrate (16) placed on the substrate-support means (15),
**characterised in that**:
• it further comprises auxiliary compensation means (21) maintaining at a substantially constant level the impedance of the plasma seen by the controlled bombardment-energy generator (17) in the case of variations in gas entry rate and maintaining the gas aspiration rate substantially constant,
• the auxiliary compensation means (21) comprising controlled means for injection into the vacuum chamber (1) of at least one passive control gas (G3) in a zone (25) close to the controlled gas-aspiration means (3) so as to avoid ionisation thereof,
• these injection means being controlled by control means (23) so as to maintain at a substantially constant level the total flow of injection of gas into the vacuum chamber (1).
